# EUROPEAN PATENT APPLICATION

(11) **EP 4 636 732 A1**
(43) Date of publication of application: **22.10.2025**
(21) Application number: 23903706.2
(22) Date of filing: 16.10.2023
(51) Int. Cl.: G08G 5/00, H01M 10/48, B64D 27/24, B64D 47/00, B64D 45/00

(54) **UAM MANAGEMENT DEVICE, AND METHOD FOR OPERATING SAME**

(30) Priority: 16.12.2022 KR 20220177591
(71) Applicant: LG Energy Solution, Ltd., Seoul 07335 (KR)
(72) Inventor: PARK, Jun Cheol, Daejeon 34122 (KR); KIM, Jeong Wan, Daejeon 34122 (KR)
(74) Representative: Plasseraud IP
(86) International application number: PCT/KR2023/015934
(87) International publication number: WO 2024/128502

(57) **Abstract**

A UAM management device according to an embodiment disclosed in the present document may include an acquisition part configured to acquire flight data, which are collected from a first urban air mobility (UAM) vehicle in flight, from the first UAM vehicle, and an evaluation part configured to evaluate whether a second UAM vehicle, which is on standby for flight, is capable of flight on the basis of the flight data.

## Description

### [TECHNICAL FIELD]

### CROSS-REFERENCE TO RELATED APPLICATION

This application claims priority to and the benefit of Korean Patent Application No. 10-2022-0177591 filed in the Korean Intellectual Property Office on December 16, 2022, the entire contents of which are incorporated herein by reference.

### TECHNICAL FIELD

Embodiments disclosed in the present document relate to a UAM management device and a method of operating the same.

### [BACKGROUND ART]

Urban air mobility (UAM) refers to a next-generation three-dimensional transportation service that uses electric air vehicles (eVTOL, electric vertical takeoff and landing), which may take off and land vertically within urban areas, to accommodate transportation demands between ports within urban areas without traffic congestion.

Recently, the feasibility of the UAM has gradually increased by virtue of advances in technologies related to material, batteries, controls, navigation, and the like for personal air vehicles (PAV) that were previously in the conception or testing stages.

### [DISCLOSURE]

### [TECHNICAL PROBLEM]

Embodiments disclosed in the present document may provide a UAM management device and a method of operating the same, which are capable of evaluating whether a UAM vehicle, which is on standby for flight, is capable of flight on the basis of flight data acquired from a UAM vehicle in flight.

Embodiments disclosed in the present document may provide a UAM management device and a method of operating the same, which are capable of determining a vehicle, which is optimized for flight, on the basis of flight data acquired from a UAM vehicle in flight and battery data acquired from a plurality of UAM vehicles on standby for flight.

Technical problems of the embodiments disclosed in the present document are not limited to the aforementioned technical problems, and other technical problems, which are not mentioned above, may be clearly understood by those skilled in the art from the following descriptions.

### [TECHNICAL SOLUTION]

AUAM management device according to an embodiment disclosed in the present document may include an acquisition part configured to acquire flight data, which are collected from a first urban air mobility (UAM) vehicle in flight, from the first UAM vehicle, and an evaluation part configured to evaluate whether a second UAM vehicle, which is on standby for flight, is capable of flight on the basis of the flight data.

In the UAM management device according to the embodiment disclosed in the present document, the flight data may include weather data related to at least one of a temperature, a wind velocity, and a wind direction in a flight route for the first UAM vehicle.

In the UAM management device according to the embodiment disclosed in the present document, the acquisition part may be configured to acquire battery data of a plurality of batteries included in the plurality of UAM vehicles from a plurality of UAM vehicles on standby for flight, and the UAM management device may further include a determination part configured to determine the second UAM vehicle among the plurality of UAM vehicles on the basis of the battery data.

In the UAM management device according to the embodiment disclosed in the present document, the flight data may include output data related to at least one of an output voltage or an output current of a battery included in the first UAM vehicle, and the determination part may determine the second UAM vehicle among the plurality of UAM vehicles further on the basis of the output data.

In the UAM management device according to the embodiment disclosed in the present document, the state data may include data related to at least one of temperatures, states of charge (SOC), states of health (SOH), output voltages, and output currents of the plurality of batteries.

A method of operating a UAM management device according to an embodiment disclosed in the present document may include: acquiring flight data, which are collected from a first urban air mobility (UAM) vehicle in flight, from the first UAM vehicle; and evaluating whether a second UAM vehicle, which is on standby for flight, is capable of flight on the basis of the flight data.

In the method of operating a UAM management device according to the embodiment disclosed in the present document, the flight data may include weather data related to at least one of a temperature, a wind velocity, and a wind direction in a flight route for the first UAM vehicle.

The method of operating a UAM management device according to the embodiment disclosed in the present document may further include: acquiring battery data of a plurality of batteries included in the plurality of UAM vehicles from a plurality of UAM vehicles on standby for flight; and determining the second UAM vehicle among the plurality of UAM vehicles on the basis of the battery data.

In the method of operating a UAM management device according to the embodiment disclosed in the present document, the flight data may include output data related to at least one of an output voltage or an output current of a battery included in the first UAM vehicle, and the determining of the second UAM vehicle may include determining the second UAM vehicle among the plurality of UAM vehicles further on the basis of the output data.

In the method of operating a UAM management device according to the embodiment disclosed in the present document, the state data may include data related to at least one of temperatures, states of charge (SOC), states of health (SOH), output voltages, and output currents of the plurality of batteries.

### [ADVANTAGEOUS EFFECTS]

The UAM management device and the method of operating the same according to various embodiments disclosed in the present document may evaluate whether the UAM vehicle, which is on standby for flight, is capable of flight on the basis of the flight data acquired from the UAM vehicle in flight, thereby preventing unexpected situations caused by weather.

The UAM management device and the method of operating the same according to various embodiments disclosed in the present document may determine the vehicle, which is optimized for flight, on the basis of the battery output data acquired from the UAM vehicle in flight and the battery data acquired from the plurality of UAM vehicles on standby for flight.

The effects of the UAM management device and the method of operating the same according to the disclosure of the present document are not limited to the aforementioned effects, and other effects, which are not mentioned above, will be clearly understood by those skilled in the art from the disclosure of the present document.

In addition, various effects that can be directly or indirectly identified through the present document may be provided.

### [DESCRIPTION OF DRAWINGS]

FIG. 1 is a block diagram of a UAM management device according to the embodiment.
FIG. 2 is an operational flowchart for the UAM management device according to the embodiment.
FIG. 3 is an operational flowchart for the UAM management device according to the embodiment.
FIG. 4 is a block diagram illustrating a hardware configuration of a computing system for performing a method of operating the UAM management device according to the embodiment.

### [Mode for Invention]

Hereinafter, various embodiments of the present invention disclosed herein will be described with reference to the accompanying drawings. However, the description of the embodiments is not intended to limit the present invention to the particular embodiments, but it should be understood that the present invention is to cover all modifications, equivalents, and/or alternatives of the embodiments of the present invention.

Various embodiments of the present document and the terms used in the embodiments are not intended to limit the technical features disclosed in the present document to the particular embodiments and should be understood as including various alterations, equivalents, or alternatives of the corresponding embodiments. In connection with the description of the drawings, the same or similar reference numerals may be used for the similar components. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Unless specifically stated to the contrary, the terms such as "1st," "2nd," "first," "second," "A," "B," "(a)," or "(b)" may be used to simply distinguish a corresponding component from another component and does not limit the corresponding components in other aspect (e.g., importance or order).

In the present document, when an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

According to the embodiment, a method according to various embodiments disclosed in the present document may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each constituent element (e.g., module or program), among the above-mentioned constituent elements, may include a single object or a plurality of objects, and some of the plurality of objects may be disposed separately in different constituent elements. According to various embodiments, one or more constituent elements, among the above-mentioned constituent elements, or operations may be omitted, or one or more other constituent elements or operations may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or a plurality of operations may be executed in a different order or omitted, or one or more other operations may be added.

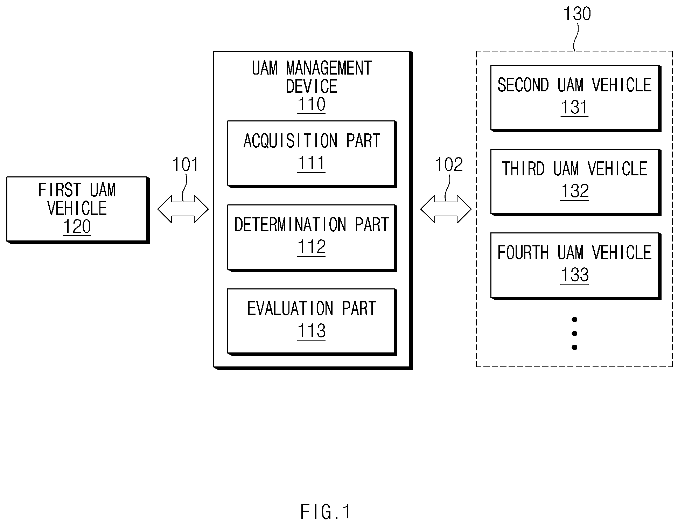

FIG. 1 is a block diagram of a UAM management device according to the embodiment.

With reference to FIG. 1, a UAM management device 110 may be connected to a first UAM vehicle 120 and a plurality of UAM vehicles 130 in a wired and/or wireless manner. In this case, the first UAM vehicle may be a vehicle in flight, and the plurality of UAM vehicles 130 may be vehicles on standby for flight.

According to the embodiment, connection 101 (or connection 102) between the UAM management device 110 and the first UAM vehicle 120 (or the plurality of UAM vehicles 130) may be a communication connection through a wired and/or wireless network. According to the embodiment, the wired network may be based on a local area network (LAN) communication or an electric power line communication. According to the embodiment, the wireless network may be based on a local area communication network (e.g., Bluetooth, wireless fidelity (WiFi), or infrared data association (IrDA)) or a distant area communication network (cellular network, 4G network, or 5G network).

According to another embodiment, the connection 101 (or connection 102) between the UAM management device 110 and the first UAM vehicle 120 (or the plurality of UAM vehicles 130) may be connection through a device-to-device communication method (e.g., bus, general purpose input and output (GPIO), serial peripheral interface (SPI), or mobile industry processor interface (MIPI)).

According to the embodiment, the UAM management device 110 may include an acquisition part 111, a determination part 112, and/or an evaluation part 113. According to the embodiment, the UAM management device 110 illustrated in FIG. 1 may further include at least one component (e.g., a display, an input device, or an output device) in addition to the components illustrated in FIG. 1.

According to the embodiment, the acquisition part 111 may acquire flight data from the first UAM vehicle 120. In this case, the flight data may be data collected from the first UAM vehicle 120.

According to the embodiment, the flight data may include weather data related to at least one of temperature, wind velocity, or wind direction in a flight route for the first UAM vehicle 120. According to the embodiment, the flight data may include output data related to at least one of an output voltage or an output current of a battery included in the first UAM vehicle 120.

According to the embodiment, the acquisition part 111 may acquire battery data from the plurality of UAM vehicles 130. According to the embodiment, the battery data may include data related to at least one of temperatures, state of charge (SOC), state of health (SOH), output voltages, or output currents of a plurality of batteries included in the plurality of UAM vehicles 130.

According to the embodiment, the determination part 112 may determine an optimal UAM vehicle among the plurality of UAM vehicles 130 on the basis of the battery data. For example, on the basis of the battery data, the determination part 112 may determine a UAM vehicle 131, 132, or 133, which includes a battery having a temperature, a SOC, and/or a SOH optimized for flight, as the optimal UAM vehicle.

According to the embodiment, the determination part 112 may determine the optimal UAM vehicle among the plurality of UAM vehicles 130 on the basis of the output data included in the flight data. For example, the determination part 112 may determine the UAM vehicle 131, 132, or 133, which includes the battery, which has the same output voltage and/or output current as the battery of the first UAM vehicle 120, as the optimal UAM vehicle.

According to the embodiment, the evaluation part 113 may evaluate whether the plurality of UAM vehicles 130 is capable of flight on the basis of the flight data. According to the embodiment, the evaluation part 113 may evaluate whether the plurality of UAM vehicles 130 is capable of flight on the basis of a weather situation in the flight route for the first UAM vehicle 120. For example, in case that the weather situation in the flight route for the first UAM vehicle 120 is a situation unsuitable for flight, the evaluation part 113 may evaluate that the plurality of UAM vehicles 130 is incapable of flight on the basis of the weather data included in the flight data.

According to the embodiment, the evaluation part 113 may evaluate whether the second UAM vehicle 131 is capable of flight on the basis of the flight data. In this case, the second UAM vehicle 131 may be a UAM vehicle determined as the optimal UAM vehicle by the determination part 112. According to the embodiment, the evaluation part 113 may evaluate whether the second UAM vehicle 131 is capable of flight on the basis of the weather situation in the flight route for the first UAM vehicle 120. For example, in case that the weather situation in the flight route for the first UAM vehicle 120 is a situation unsuitable for flight, the evaluation part 113 may evaluate that the second UAM vehicle 131 is incapable of flight on the basis of the weather data included in the flight data.

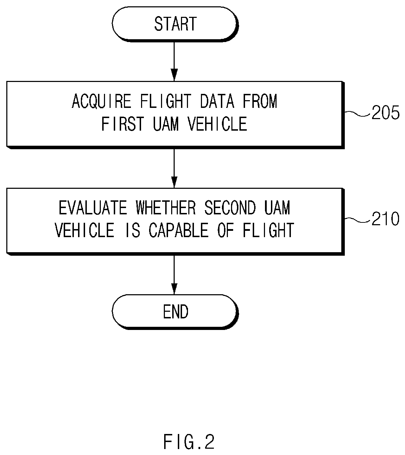

FIG. 2 is an operational flowchart for the UAM management device according to the embodiment. FIG. 2 may be described with reference to the components in FIG. 1.

The embodiment illustrated in FIG. 2 is only one embodiment. The order of the steps according to various embodiments of the present invention may be different from that illustrated in FIG. 2. Some of the steps illustrated in FIG. 2 may be excluded, the order of the steps may be changed, or the steps may be combined.

With reference to FIG. 2, at operation 205, the UAM management device 110 may acquire the flight data from the first UAM vehicle 120. In this case, the flight data may be data collected from the first UAM vehicle 120 in flight.

According to the embodiment, the flight data may include weather data related to at least one of temperature, wind velocity, or wind direction in a flight route for the first UAM vehicle 120. According to the embodiment, the flight data may include output data related to at least one of an output voltage or an output current of a battery included in the first UAM vehicle 120.

At operation 210, the UAM management device 110 may evaluate whether the second UAM vehicle 131 is capable of flight. In this case, the second UAM vehicle 131 may be a UAM vehicle on standby for flight.

According to the embodiment, the UAM management device 110 may evaluate whether the second UAM vehicle 131 is capable of flight on the basis of the flight data acquired at operation 205. According to the embodiment, the UAM management device 110 may evaluate whether the second UAM vehicle 131 is capable of flight on the basis of the weather situation in the flight route for the first UAM vehicle 120. For example, in case that the weather situation in the flight route for the first UAM vehicle 120 is a situation unsuitable for flight, the UAM management device 110 may evaluate that the second UAM vehicle 131 is incapable of flight on the basis of the weather data included in the flight data.

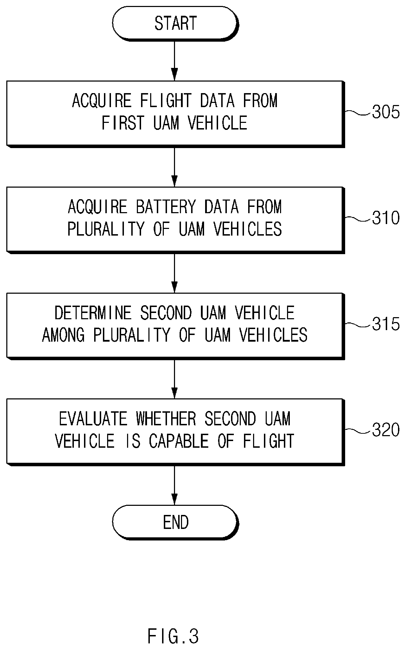

FIG. 3 is an operational flowchart for the UAM management device according to the embodiment. FIG. 3 may be described with reference to the components in FIG. 1.

The embodiment illustrated in FIG. 3 is only one embodiment. The order of the steps according to various embodiments of the present invention may be different from that illustrated in FIG. 3. Some of the steps illustrated in FIG. 3 may be excluded, the order of the steps may be changed, or the steps may be combined.

With reference to FIG. 3, at operation 305, the UAM management device 110 may acquire the flight data from the first UAM vehicle 120. In this case, the flight data may be data collected from the first UAM vehicle 120 in flight.

According to the embodiment, the flight data may include weather data related to at least one of temperature, wind velocity, or wind direction in a flight route for the first UAM vehicle 120. According to the embodiment, the flight data may include output data related to at least one of an output voltage or an output current of a battery included in the first UAM vehicle 120.

At operation 310, the UAM management device 110 may acquire the battery data from the plurality of UAM vehicles 130. According to the embodiment, the battery data may include data related to at least one of temperatures, states of charge (SOC), states of health (SOH), output voltages, and output currents of a plurality of batteries included in the plurality of UAM vehicles 130.

At operation 315, the UAM management device 110 may determine the second UAM vehicle 131 among the plurality of UAM vehicles 130. In this case, the second UAM vehicle 131 may be an optimal UAM vehicle among the plurality of UAM vehicles 130 on standby for flight.

According to the embodiment, the UAM management device 110 may determine the second UAM vehicle 131 among the plurality of UAM vehicles 130 on the basis of the battery data acquired at operation 310. For example, on the basis of the battery data, the UAM management device 110 may determine the second UAM vehicle 131 including the battery having the temperature, the SOC, and/or the SOH optimized for flight.

According to the embodiment, the UAM management device 110 may determine the second UAM vehicle 131 among the plurality of UAM vehicles 130 on the basis of the output data included in the flight data. For example, the UAM management device 110 may determine the second UAM vehicle 131 including the battery having the same output voltage and/or output current as the battery of the first UAM vehicle 120.

At operation 320, the UAM management device 110 may evaluate whether the second UAM vehicle 131 is capable of flight that is determined at operation 315.

According to the embodiment, the UAM management device 110 may evaluate whether the second UAM vehicle 131 is capable of flight on the basis of the flight data acquired at operation 205. According to the embodiment, the UAM management device 110 may evaluate whether the second UAM vehicle 131 is capable of flight on the basis of the weather situation in the flight route for the first UAM vehicle 120. For example, in case that the weather situation in the flight route for the first UAM vehicle 120 is a situation unsuitable for flight, the UAM management device 110 may evaluate that the second UAM vehicle 131 is incapable of flight on the basis of the weather data included in the flight data.

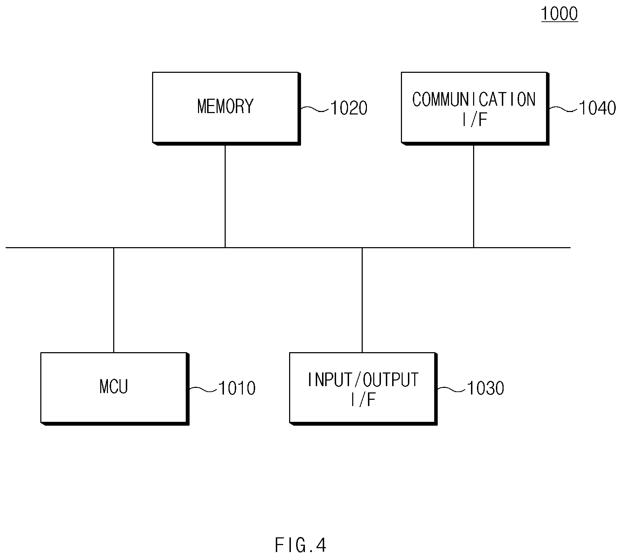

FIG. 4 is a block diagram illustrating a hardware configuration of a computing system for performing a method of operating the UAM management device according to the embodiment. FIG. 4 may be described with reference to the components in FIG. 1.

With reference to FIG. 4, a computing system 1000 may include a microcontroller unit (MCU) 1010, a memory 1020, an input/output I/F 1030, and a communication I/F 1040.

The MCU 1010 may include a central processing unit, an application processor, a graphic processing device, a neural processing device (NPU), an image signal processor, a sensor hub processor, or a communication processor.

The MCU 1010 may be a processor that executes programs (e.g., the acquisition part 111, the determination part 112, and the evaluation part 113) stored in the memory 1020 and processes various types of information, which include the determination of the second UAM vehicle 131 and/or the evaluation of whether the second UAM vehicle 131 is capable of flight, through the programs.

The memory 1020 may store various types of data such as the flight data of the first UAM vehicle 120 and the battery data of the plurality of UAM vehicles 130. In addition, the memory 1020 may store various types of programs such as the acquisition part 111, the determination part 112, and the evaluation part 113.

The memory 1020 may be provided as a plurality of memories 1020, as necessary. The memory 1020 may be a volatile memory or a non-volatile memory. A RAM, a DRAM, an SRAM, or the like may be used as the memory 1020 that is the volatile memory. A ROM, a PROM, an EAROM, an EPROM, an EEPROM, a flash memory, or the like may be used as the memory 1020 that is the non-volatile memory. The above-listed examples of the memory 1020 are merely illustrative, and the memory 1020 is not limited to this example.

The input/output I/F 1030 may provide an interface configured to connect an input device (not illustrated), such as a keyboard, mouse, or touch panel, and an output device, such as a display (not illustrated), to the MCU 1010 so that the input device, the output device, and the MCU may transmit and receive data.

The communication I/F 1040 may establish a wired communication channel and/or a wireless communication channel between the UAM management device 110, the first UAM vehicle 120, and/or the plurality of UAM vehicles 130 and transmit and receive data to and from the first UAM vehicle 120 and/or the plurality of UAM vehicles 130 via the established communication channel.

As described above, the computer program according to the embodiment disclosed in the present document may be recorded in the memory 1020 and processed by the MCU 1010.

Unless explicitly described to the contrary, the words "comprise," "include," or "have" and variations such as "comprises," "comprising," "includes," "including," has," or "having," should be understood to imply the inclusion of stated elements but not the exclusion of any other elements. Unless otherwise defined, all terms including technical or scientific terms may have the same meaning as commonly understood by those skilled in the art to which the embodiments disclosed in the present document pertain. The terms such as those defined in a commonly used dictionary may be interpreted as having meanings consistent with meanings in the context of related technologies and may not be interpreted as ideal or excessively formal meanings unless explicitly defined in the present document.

## Claims

1. A UAM management device comprising:
an acquisition part configured to acquire flight data, which are collected from a first urban air mobility (UAM) vehicle in flight, from the first UAM vehicle; and
an evaluation part configured to evaluate whether a second UAM vehicle, which is on standby for flight, is capable of flight on the basis of the flight data.

2. The UAM management device of claim 1, wherein the flight data include weather data related to at least one of a temperature, a wind velocity, and a wind direction in a flight route for the first UAM vehicle.

3. The UAM management device of claim 1, wherein the acquisition part is configured to acquire battery data of a plurality of batteries included in the plurality of UAM vehicles from a plurality of UAM vehicles on standby for flight, and
wherein the UAM management device further comprises a determination part configured to determine the second UAM vehicle among the plurality of UAM vehicles on the basis of the battery data.

4. The UAM management device of claim 3, wherein the flight data include output data related to at least one of an output voltage or an output current of a battery included in the first UAM vehicle, and the determination part determines the second UAM vehicle among the plurality of UAM vehicles further on the basis of the output data.

5. The UAM management device of claim 4, wherein the state data include data related to at least one of temperatures, states of charge (SOC), states of health (SOH), output voltages, and output currents of the plurality of batteries.

6. A method of operating a UAM management device, the method comprising:
acquiring flight data, which are collected from a first urban air mobility (UAM) vehicle in flight, from the first UAM vehicle; and
evaluating whether a second UAM vehicle, which is on standby for flight, is capable of flight on the basis of the flight data.

7. The method of claim 6, wherein the flight data include weather data related to at least one of a temperature, a wind velocity, and a wind direction in a flight route for the first UAM vehicle.

8. The method of claim 6, further comprising:
acquiring battery data of a plurality of batteries included in the plurality of UAM vehicles from a plurality of UAM vehicles on standby for flight; and
determining the second UAM vehicle among the plurality of UAM vehicles on the basis of the battery data.

9. The method of claim 8, wherein the flight data include output data related to at least one of an output voltage or an output current of a battery included in the first UAM vehicle, and the determining of the second UAM vehicle comprises determining the second UAM vehicle among the plurality of UAM vehicles further on the basis of the output data.

10. The method of claim 9, wherein the state data include data related to at least one of temperatures, states of charge (SOC), states of health (SOH), output voltages, and output currents of the plurality of batteries.
